**Europäisches Patentamt**

**European Patent Office**

**Office européen des brevets**

(19)

(11) Veröffentlichungsnummer : **0 040 816**
**B1**

(12) **EUROPÄISCHE PATENTSCHRIFT**

(45) Veröffentlichungstag der Patentschrift :
16.11.83

(51) Int. Cl.³ : **H 01 L 29/747**, H 01 L 23/56,
H 01 L 27/06

(21) Anmeldenummer : 81103894.2

(22) Anmeldetag : 20.05.81

(54) Zweirichtungsthyristor.

(30) Priorität : 23.05.80 DE 3019883

(43) Veröffentlichungstag der Anmeldung :
02.12.81 Patentblatt 81/48

(45) Bekanntmachung des Hinweises auf die Patenterteilung : 16.11.83 Patentblatt 83/46

(84) Benannte Vertragsstaaten :
DE FR GB

(56) Entgegenhaltungen :
DE A 2 022 925
US A 3 350 611

(73) Patentinhaber : SIEMENS AKTIENGESELLSCHAFT
Berlin und München Wittelsbacherplatz 2
D-8000 München 2 (DE)

(72) Erfinder : Tihanyi, Jenö, Dr., Ing. Dipl.-Phys.
Wolfratshauser Strasse 179 b
D-8000 München 71 (DE)

Zweirichtungsthyristor

Die Erfindung bezieht sich auf einen Zweirichtungsthyristor (Triac) mit zwei in einen Halbleiterkörper integrierten, antiparallel geschalteten Teilthyristoren, die jeweils eine katodenseitige Emitterzone, eine katodenseitige Basiszone, eine anodenseitige Emitterzone und eine beiden Teilthyristoren gemeinsam zugehörige anodenseitige Basiszone aufweisen, und der eine Hilfszone besitzt.

Ein solcher Zweirichtungsthyristor, der im folgenden der Einfachheit halber als « Triac » bezeichnet wird, ist z. B. im US-Patent 3 350 611 beschrieben worden. Er besteht im wesentlichen aus zwei in einen einzigen Halbleiterkörper integrierten, antiparallel geschalteten Teilthyristoren, deren äußere Zonen jeweils über eine Elektrode miteinander verbunden sind. Der Triac wird dadurch eingeschaltet, daß der katodenseitigen Basiszone des einen Teilthyristors ein Steuerstrom zugeführt wird. Um eine Zündung mit Ladungsträgern der anderen Polarität zu ermöglichen, ist in der katodenseitigen Basiszone dieses Teilthyristors eine Hilfszone des der katodenseitigen Basiszone entgegengesetzten Leitungstyps eingebettet. Je nach Polarität des eingespeisten Steuerstroms wird dann die Zündung direkt oder über die genannte Hilfszone eingeleitet. Je nach Größe des Triac muß der Steuerstrom zum sicheren und schnellen Zünden in der Größenordnung zwischen 15 und 50 mA liegen. Eine direkte Ansteuerung durch Mikrocomputer oder LSI-Schaltkreise ist damit nicht möglich, da diese im allgemeinen nur Ausgangsströme in der Größenordnung von 1 mA liefern.

Der Erfindung liegt die Aufgabe zugrunde, einen Triac der eingangs erwähnten Art so weiterzubilden, daß er mit wesentlich geringeren Ansteuerleistungen, insbesondere direkt von Mikroprozessoren oder LSI-Schaltkreisen angesteuert werden kann.

Die Erfindung ist dadurch gekennzeichnet, daß die Katodenseitige Emitterzone des ersten Teilthyristors mit der beiden Teilthyristoren gemeinsam zugehörigen anodenseitigen Basiszone über die Laststrecke eines in den Halbleiterkörper integrierten Feldeffekttransistors (FET) derart verbunden ist, daß der Sourceanschluß des FET an der katodenseitigen Emitterzone liegt, und daß in der beiden Teilthyristoren gemeinsam zugehörigen anodenseitigen Basiszone die Hilfszone vom Leitfähigkeitstyp der anodenseitigen Emitterzone des zweiten Teilthyristors angeordnet ist.

In der DE-A-2 022 925 ist bereits ein Thyristor beschrieben worden, in dessen Halbleiterkörper ein Feldeffekttransistor integriert ist. Dadurch ist dieser Thyristor mit geringen Ansteuerleistungen einschaltbar. Konkrete Vorschläge, wie ein Triac durch den integrierten Feldeffekttransistor einschaltbar ist, sind diesem Dokument jedoch nicht zu entnehmen.

Weiterbildungen sind Gegenstand der Unteransprüche.

Die Erfindung wird an Hand zweier Ausführungsbeispiele in Verbindung mit den Fig. 1 bis 7 näher erläutert. Es zeigen.

Figuren 1 und 2 eine schematische Darstellung eines ersten Ausführungsbeispiels der Erfindung in zwei verschiedenen Betriebszuständen,

Figur 3 eine schematische Darstellung eines zweiten Ausführungsbeispiels der Erfindung,

Figur 4 die Aufsicht auf einen lateralen Triac, der vom Prinzip nach den Fig. 1 und 2 Gebrauch macht und

Figuren 5, 6 und 7 Schnitte durch den Triac nach Fig. 4 entlang der eingezeichneten Schnittlinien.

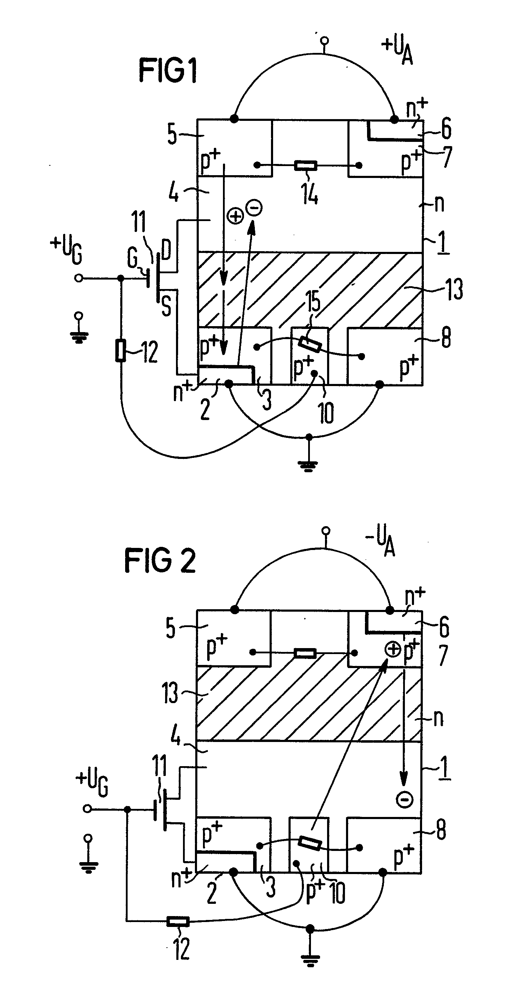

In Fig. 1 ist schematisch der Schnitt durch einen Halbleiterkörper 1 eines Triac dargestellt. Er enthält zwei antiparallel geschaltete, in den Halbleiterkörper integrierte Teilthyristoren. Der erste Teilthyristor auf der linken Seite hat eine stark n-dotierte katodenseitige Emitterzone 2, eine katodenseitige Basiszone 3, eine anodenseitige Basiszone 4 und eine anodenseitige Emitterzone 5. Die entsprechenden Zonen des antiparallel geschalteten zweiten Teilthyristors auf der rechten Seite sind 6, 7, 4, 8. Die katodenseitige Emitterzone 2 des ersten Teilthyristors ist mit der den beiden Teilthyristoren gemeinsamen anodenseitigen schwach n-dotierten Basiszone 4 über die Laststrecke eines FET 11 verbunden. Unter Laststrecke ist dabei die Strecke Sourcezone-Steuerzone-Drainzone des FET verstanden. Die Anschlüsse des FET 11 sind mit S für Sourcezone, D für Drainzone und G für Steueranschluß versehen. Zwischen der katodenseitigen Basiszone 3 des linken Teilthyristors und der anodenseitigen Emitterzone 8 des anderen Teilthyristors ist eine Hilfszone 10 angeordnet, die gleichen Leitfähigkeitstyp wie die Zonen 3 und 8, 5 und 7 aufweist. Im vorliegenden Fall sind diese Zonen stark p-dotiert. Zwischen den Zonen 3 und 8 beziehungsweise 5 und 7 sind Widerstände 15 beziehungsweise 14 eingezeichnet, die in bekannter Weise zur Verbesserung des du/dt-Verhaltens dienen. Die Hilfszone 10 ist über einen Widerstand 12 elektrisch mit dem Steueranschluß G des FET 11 verbunden.

Bei der eingezeichneten Polarität der Spannung $+U_A$ baut sich in der Zone 4 eine Raumladungszone 13 auf, die schraffiert dargestellt ist. Mit dieser Polarität ist der erste Teilthyristor in Kipprichtung vorgespannt und der pn-Übergang zwischen den Zonen 3 und 4 sperrt. Wird auf den Steuereingang des FET 11 ein Steuersignal $+U_G$ gegeben, so wird dieser leitend gesteuert und aus der Zone 2 fließen über die Laststrecke des FET 11 negative Ladungsträger in die Zone 4. Dies ruft eine Emission von positiven Ladungsträgern aus der Zone 5 hervor, die sich in Richtung der Zone 3 bewegen. Gleichzeitig emittiert die Zone 2 negative Ladungsträger, die sich zum pn-Übergang zwischen den Zonen 3 und 4 bewegen. Dieser wird dann in Flußrichtung vorgespannt und der erste Teilthyristor zündet.

Der zweite (rechte) Teilthyristor ist bei der eingezeichneten Polarität außer Funktion. Die Hilfszone 10 ist ebenso außer Funktion, da der pn-Übergang zwischen dieser und der Zone 4 gesperrt ist.

Da der FET 11 bis auf einen zwischen dem Steueranschluß G und der Sourcezone S fließenden kapazitiven Strom zum Einschalten keinen Strom benötigt, wird der Triac praktisch leistungslos eingeschaltet.

Bei umgekehrter Polarität der Spannung ($-U_A$) ergeben sich etwas andere Verhältnisse. Diese sind in Fig. 2 dargestellt. Es ist ersichtlich, daß nunmehr der zweite Teilthyristor in Kipprichtung vorgespannt ist, das heißt, der pn-Übergang zwischen den Zonen 7 und 4 ist gesperrt. Wird auf den Steuereingang des FET 11 ein positives Signal gegeben, so wird der FET leitend gesteuert. Damit wird die Zone 4 im raumladungsfreien Teil auf das Potential « 0 » gelegt. Gleichzeitig fließt ein geringer Steuerstrom über den Widerstand 12 in die Hilfszone 10. Diese emittiert positive Ladungsträger in die Zone 4, da nun der pn-Übergang zwischen der Zone 10 und der Zone 4 in Durchlaßrichtung gepolt ist. Die positiven Ladungsträger fließen damit unter anderem zur Zone 7, was eine Emission von negativen Ladungsträgern aus der Zone 6 hervorruft. Dies wiederum verursacht eine Emission von positiven Ladungsträgern aus der anodenseitigen Emitterzone 8 des rechten Teilthyristors. Damit wird der pn-Übergang zwischen den Zonen 7 und 4 in Durchlaßrichtung vorgespannt und der zweite Teilthyristor zündet.

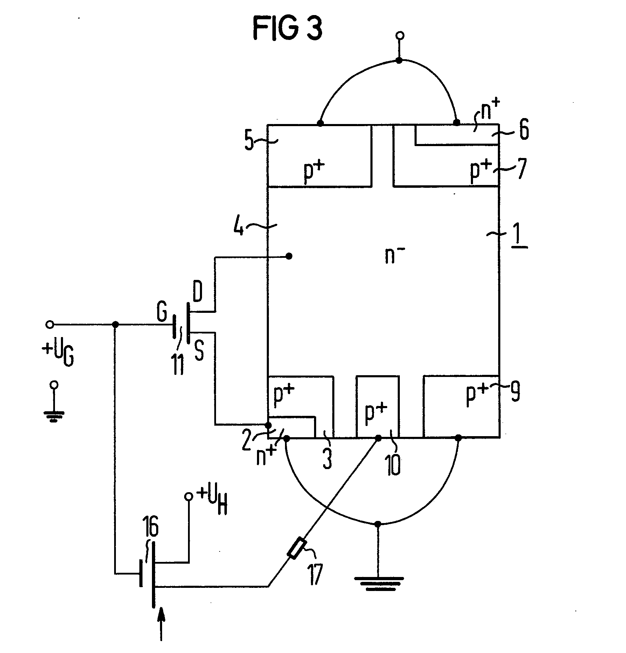

Beim Schaltzustand nach Fig. 2 wird die Steuerspannungsquelle mit einem geringfügigen, im wesentlichen durch den Widerstand 12 bestimmten Strom belastet. Dieser Strom kann bei etwa 1 bis 5 mA liegen. Die Belastung der Steuerspannungsquelle, das heißt des Mikrocomputers oder des LSI-Schaltkreises, läßt sich weiter vermindern, wenn die Anordnung nach Fig. 1 und 2 um einen zusätzlichen FET erweitert wird. Eine solche Anordnung ist in Fig. 3 dargestellt. Die Hilfszone 10 ist hier über einen Widerstand 17 und die Laststrecke eines zweiten, in den Halbleiterkörper integrierbaren FET 16 mit einer Hilfsspannungsquelle $-U_H$ verbunden. Der Steueranschluß des FET 16 ist mit dem Steueranschluß des FET 11 elektrisch verknüpft. Der geringe Steuerstrom kommt also hier nicht aus dem Mikrocomputer, sondern aus einer separaten Stromquelle, die zur Stromversorgung des Mikrocomputers oder des LSI-Kreises ohnehin vorgesehen sein muß. Die Wirkungsweise der Anordnung nach Fig. 3 ist analog der nach den Fig. 1 und 2.

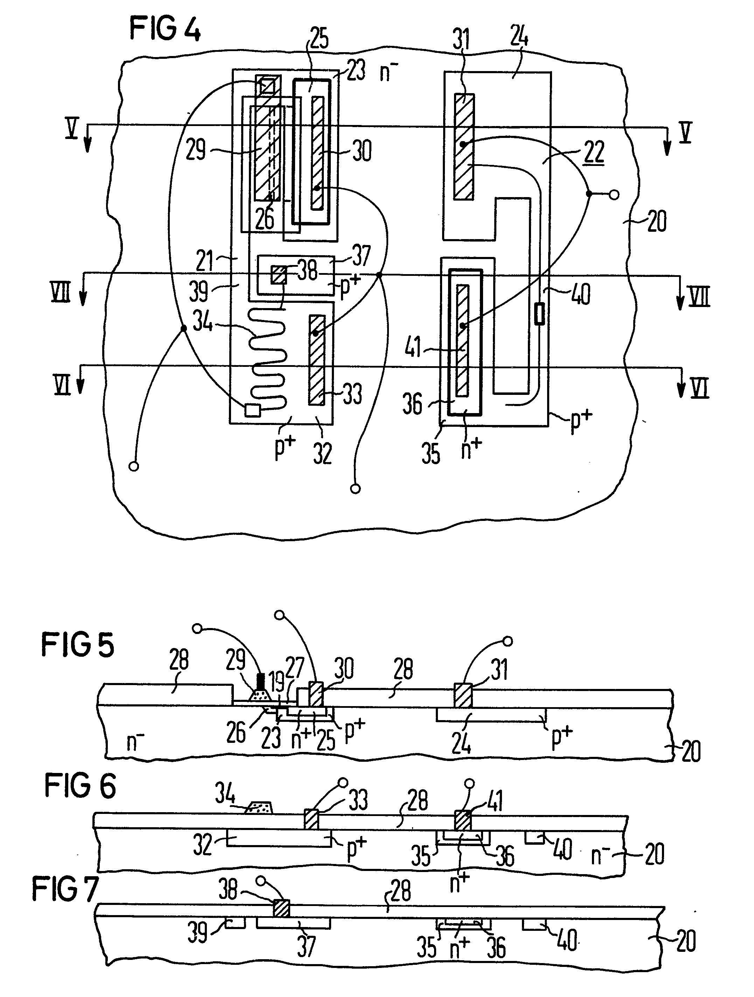

Eine funktionsfähige laterale Ausführungsform des Triac ist in den Fig. 4, 5, 6 und 7 dargestellt. Der Aufbau und die Wirkungsweise wird durch Bezugnahme auf alle diese Figuren erläutert.

Die beiden Teilthyristoren und der FET sind auf einem Substrat 20 angeordnet, das schwach n-leitend ist. In dieses Substrat sind zwei stark p-leitende Bereiche 21 und 22 eingebettet. Der Bereich 21 enthält die katodenseitige Basiszone 23 des ersten Teilthyristors und die anodenseitige Emitterzone 32 des zweiten Teilthyristors. Die genannten Zonen sind durch einen schmalen Steg 39 miteinander verbunden, der die Funktion des Widerstands 15 in Fig. 1 übernimmt. Der Bereich 21 hat eine Aussparung, die von den Zonen 23, 32 und vom Steg 39 begrenzt wird. In dieser Aussparung sitzt die Hilfszone 37, die der Hilfszone 10 in Fig. 1 entspricht. Sie ist mit einem Kontakt 38 versehen, während die Zone 32 einen Kontakt 33 aufweist.

Der Bereich 22 setzt sich zusammen aus der anodenseitigen Emitterzone 24 des ersten Teilthyristors und der katodenseitigen Basiszone 35 des ersten Teilthyristors. Beide Zonen sind durch einen Steg 40 miteinander verbunden, der die Funktion des Nebenschlußwiderstands 14 (Fig. 1 und 2) übernimmt. Die Zone 24 ist mit einem Kontakt 31 versehen.

Die Zonen 23, 24, 32, 35, 37 und die Stege 39, 40 werden zweckmäßigerweise durch den gleichen Diffusionsschritt hergestellt, haben demnach gleichen Leitfähigkeitstyp und gleiche Dicke. Im Ausführungsbeispiel sind diese Zonen stark p-dotiert. In die p-dotierte Zone 23 ist eine Zone 25 vom entgegengesetzten Leitfähigkeitstyp eingelassen. Diese bildet die katodenseitige Emitterzone des ersten Teilthyristors. Entsprechend ist in die Zone 35 eine Zone 36 vom entgegengesetzten Leitfähigkeitstyp eingebettet, die die katodenseitige Emitterzone des zweiten Teilthyristors bildet. Die Zonen 25 und 36 sind zweckmäßigerweise durch Ionenimplantation hergestellt und weisen gleiche Dicke auf. Sie sind mit Kontakten 30 beziehungsweise 41 versehen.

Mit der Zone 23 des ersten Teilthyristors hängt die Steuerzone 26 des FET zusammen. Sie hat gleichen Leitfähigkeitstyp, ist jedoch durch Ionenimplantation hergestellt. Sie verläuft schräg zur Oberfläche des Substrats, was durch eine entsprechend geformte Maske erzielt werden kann. Als Maske wird hier die Steuerelektrode 29 verwendet, die aus polykristallinem Silicium besteht. Ihre Flanken sind abgeschrägt, so daß sich entsprechend ein schräger Verlauf der Steuerzone 26 im Substrat 20 einstellt. Die Sourcezone hängt mit der katodenseitigen Emitterzone 25 des ersten Teilthyristors zusammen und ist mit 19 bezeichnet. Die anodenseitige Basiszone der Teilthyristoren und die Drainzone des FET wird durch das Substrat 20 gebildet.

Die Hilfszone 37 ist mit einem Kontakt 38 versehen, der über einen Widerstand 34 (12 in Fig. 1 und 2) mit dem Steuereingang des FET, das heißt mit der Steuerelektrode 29 verbunden ist. Der Widerstand 34 kann zum Beispiel aus aufgedampftem polykristallinen Silicium bestehen.

Die Bereiche 21 und 22 sind zweckmäßigerweise derart einander gegenüberliegend angeordnet, daß die katodenseitige Emitterzone des ersten Teilthyristors seiner anodenseitigen Emitterzone gegenüberliegt. Die Hilfszone 37 liegt zweckmäßigerweise der katodenseitigen Emitterzone 36 des zweiten Teilthyristors gegenüber, da diese Zonen im in Fig. 2 dargestellten Betriebsfall elektrisch zusammenwirken müssen.

Der Funktionsablauf des lateralen Triac nach den Fig. 4 bis 7 entspricht dem in Verbindung mit Fig. 1 und 2 erläuterten Schema. Die Verbindungen der Elektroden 31 und 41 beziehungsweise 30 und 33 sind durch diskrete Leitungen dargestellt. Sie werden jedoch zweckmäßigerweise, wie bei integrierten Schaltungen üblich, durch zum Beispiel aufgedampfte Leiterbahnen miteinander verbunden.

## Ansprüche

1. Zweirichtungsthyristor (Triac) mit zwei in einen Halbleiterkörper integrierten, antiparallel geschalteten Teilthyristoren, die jeweils eine katodenseitige Emitterzone (2, 6), eine katodenseitige Basiszone (3, 7), eine anodenseitige Emitterzone (5, 8) und eine beiden Teilthyristoren gemeinsam zugehörige anodenseitige Basiszone (4) aufweisen, und der eine Hilfszone (10) besitzt, dadurch gekennzeichnet, daß die katodenseitige Emitterzone (2) des ersten Teilthyristors mit der beiden Teilthyristoren gemeinsam zugehörigen anodenseitigen Basiszone (4) über die Laststrecke eines in den Halbleiterkörper integrierten Feldeffekttransistors (FET) (11) derart verbunden ist, daß der Sourceanschluß (S) des FET (11) an der katodenseitigen Emitterzone (2) liegt, und daß in der beiden Teilthyristoren gemeinsam zugehörigen anodenseitigen Basiszone (4) die Hilfszone (10) vom Leitfähigkeitstyp der anodenseitigen Emitterzone (8) des zweiten Teilthyristors angeordnet ist.

2. Zweirichtungsthyristor nach Anspruch 1, dadurch gekennzeichnet, daß die katodenseitigen Emitterzonen (25, 36) der Teilthyristoren und die Sourcezone (19) des FET durch Zonen des ersten Leitfähigkeitstyps gebildet sind, daß die anodenseitigen Emitterzonen (24, 32), die katodenseitigen Basiszonen (23, 35), die zu steuernde Kanalzone (26) des FET und die Hilfszone (37) durch Zonen des zweiten Leitfähigkeitstyps gebildet sind, daß die Zonen des zweiten Leitfähigkeitstyps in eine Seite eines Substrats (20) des ersten Leitfähigkeitstyps eingebettet sind, daß die katodenseitigen Emitterzonen (25, 36) des ersten Leitfähigkeitstyps in die Zonen des zweiten Leitfähigkeitstyps eingebettet sind, und daß das Substrat (20) die Drainzone des FET und die beiden Teilthyristoren gemeinsam zugehörige anodenseitige Basiszone bildet.

3. Zweirichtungsthyristor nach Anspruch 2, dadurch gekennzeichnet, daß die Zonen (19, 25, 36) des ersten Leitfähigkeitstyps durch Ionenimplantation gebildet sind.

4. Zweirichtungsthyristor nach Anspruch 2, dadurch gekennzeichnet, daß die Zonen (23, 24, 32, 35) des zweiten Leitfähigkeitstyps durch Diffusion gebildet sind und gleiche Dicke haben.

5. Zweirichtungsthyristor nach einem der Ansprüche 1 bis 4, dadurch gekennzeichnet, daß die Kanalzone (26) des FET durch Ionenimplantation gebildet und Teil der katodenseitigen Basiszone (23) des ersten Teilthyristors ist.

6. Zweirichtungsthyristor nach einem der Ansprüche 1 bis 5, dadurch gekennzeichnet, daß die katodenseitige Basiszone (23 bzw. 35) jeweils des einen Teilthyristors mit der anodenseitigen Emitterzone (32 bzw. 24) jeweils des anderen Teilthyristors je einen über einen vergleichsweise schmalen Steg (39 bzw. 40) zusammenhängenden, in das Substrat (20) eingebetteten, ersten (21) beziehungsweise zweiten (22) Bereich bildet.

7. Zweirichtungsthyristor nach Anspruch 6, dadurch gekennzeichnet, daß die Bereiche (21, 22) auf einer Seite des Substrats (20) derart angeordnet sind, daß die katodenseitige Emitterzone (24, 36) des einen der Teilthyristoren einem Kontakt (31, 33) für die anodenseitige Emitterzone (24, 32) des anderen der Teilthyristoren gegenüberliegt.

8. Zweirichtungsthyristor nach Anspruch 7, dadurch gekennzeichnet, daß die Hilfszone (37) in einer von der katodenseitigen Basiszone (23) des ersten Teilthyristors, dem Steg (39) und der anodenseitigen Emitterzone (32) des zweiten Teilthyristors begrenzten Aussparung des ersten Bereichs (21) im Substrat (20) angeordnet ist.

9. Zweirichtungsthyristor nach einem der Ansprüche 1 bis 8, dadurch gekennzeichnet, daß der Kontakt (38) der Hilfszone (37) über einen Widerstand (34) mit der Steuerelektrode (29) des FET verbunden ist.

10. Zweirichtungsthyristor nach einem der Ansprüche 1 bis 8, dadurch gekennzeichnet, daß der Kontakt der Hilfszone über die Laststrecke eines zweiten integrierten FET (16) an eine Hilfsspannung ($U_H$) anschaltbar ist, und daß die Steuerelektrode des zweiten FET mit der Steuerelektrode des ersten FET verbunden ist.

## Claims

1. A bidirectional thyristor (Triac) having two sub-thyristors integrated into a semiconductor body and connected antiparallel and which respectively possess cathode-side emitter zones (2, 6), cathode-side base zones (3, 7), and anode-side emitter zones (5, 8), and an anode-side base zone (4) which is common to both sub-thyristors, and said bidirectional thyristor having an auxiliary zone (10), characterised in that the cathode-side emitter zone (2) of the first sub-thyristor is connected to the anode-side base zone (4), which is common to the two sub-thyristors, by way of the load path of a field effect transistor (FET) (11), which is integrated into the semiconductor body, in such a way that the source terminal (S) of the FET (11) is connected to the cathode-side emitter zone (2) ; and that in the anode-side base zone (4) which is common to the two sub-thyristors, there is arranged the auxiliary zone (10) of the conductivity type of the anode-side emitter zone (8) of the second sub-thyristor.

2. A bidirectional thyristor as claimed in Claim 1, characterised in that the cathode-side emitter zones (25, 36) of the sub-thyristors and the source zone (19) of the FET are formed by zones of the first conductivity type ; that the anode-side emitter zones (24, 32), the cathode-side base zones (23, 35), the controllable channel zone (26) of the FET and the auxiliary zone (37) are formed by zones of the second conductivity type ; that the zones of the second conductivity type are embedded in one side of a substrate (20) of the first conductivity type ; that the cathode-side emitter zones (25, 36) of the first conductivity type are embedded in the zones of the second conductivity type ; and that the substrate (20) forms the drain zone of the FET and the anode-side base zone which is common to the two partial thyristors.

3. A bidirectional thyristor as claimed in Claim 2, characterised in that the zones (19, 25, 36) of the first conductivity type are formed by ion implantation.

4. A bidirectional thyristor as claimed in Claim 2, characterised in that the zones (23, 24, 32, 35) of the second conductivity type are formed by diffusion and have the same thickness.

5. A bidirectional thyristor as claimed in one of Claims 1 to 4, characterised in that the channel zone (26) of the FET is formed by ion implantation and constitutes a part of the cathode-side base zone (23) of the first sub-thyristor.

6. A bidirectional thyristor as claimed in one of Claims 1 to 5, characterised in that the cathode-side base zone (23 and 35) of the one sub-thyristor, together with the anode-side emitter zone (32 and 24) of the other sub-thyristor, forms a first region (21) and a second region (22) respectively narrow cross-piece (39 and 40).

7. A bidirectional thyristor as claimed in Claim 6, characterised in that the regions (21, 22) are arranged on one side of the substrate (20) in such a way that the cathode-side emitter zone (24, 36) of the one sub-thyristor lies opposite a contact (31, 33) for the anode-side emitter zone (24, 32) of the other sub-thyristor.

8. A bidirectional thyristor as claimed in Claim 7, characterised in that the auxiliary zone (37) is arranged in a recess in the first region (21) in the substrate (20), which recess is bounded by the cathode-side base zone (23) of the first sub-thyristor, the cross-piece (39) and the anode-side emitter zone (32) of the second sub-thyristor.

9. A bidirectional thyristor as claimed in one of Claims 1 to 8, characterised in that the contact (38) of the auxiliary zone (37) is connected by way of a resistor (34) to the control electrode (29) of the FET.

10. A bidirectional thyristor as claimed in one of Claims 1 to 8, characterised in that the contact of the auxiliary zone can be connected to an auxiliary voltage ($U_H$) by way of the load path of a second integrated FET (16) ; and that the control electrode of the second FET is connected to the control electrode of the first FET.

## Revendications

1. Thyristor bidirectionnel (triac) comportant deux thyristors élémentaires intégrés dans un corps semiconducteur et branchés selon un montage antiparallèle et qui possèdent chacun une zone d'émetteur (2, 6) située du côté de la cathode, une zone de base (7, 3) située du côté de la cathode, une zone d'émetteur (5, 8) située du côté de l'anode et une zone de base (4) située du côté de l'anode et appartenant en commun aux deux thyristors élémentaires, et comportant une zone auxiliaire (10), caractérisé par le fait que la zone d'émetteur (2), située du côté de la cathode, du premier thyristor élémentaire, est reliée à la zone de base (4), située du côté de l'anode et associée en commun aux deux thyristors élémentaires, par l'intermédiaire de la voie de charge d'un transistor à effet de champ (FET) (11) intégré dans le corps semiconducteur de telle manière que la borne de source (S) du FET (11) est située sur la zone émetteur (2) située du côté de la cathode, et que la zone auxiliaire (10) possédant le type de conductivité de la zone d'émetteur (8), située du côté de l'anode, du second thyristor élémentaire, est disposée dans la zone de base (4) située du côté de l'anode et associée en commun aux deux thyristors élémentaires.

2. Thyristor bidirectionnel selon la revendication 1, caractérisé en ce que les zones d'émetteur (25, 36), situées du côté de la cathode, des thyristors élémentaires et la zone de source (19) du FET sont formées par des zones possédant le premier type de conductivité, que les zones d'émetteur (24, 32) situées du côté de l'anode, les zones de base (23, 35) situées du côté de la cathode, la zone de canal (26) devant être commandée du FET et la zone auxiliaire (37) sont formées par des zones possédant le second type de conductivité, que les zones possédant le second type de conductivité sont insérées sur un côté du substrat (20) possédant le premier type de conductivité, que les zones d'émetteur (25, 36) situées du côté de la cathode et possédant le premier type de conductivité sont insérées dans les zones possédant le second type de conductivité, et que le substrat (20) forme la zone de drain du FET et les deux zones de base, situées du côté de l'anode et associées en commaun aux deux thyristors élémentaires.

3. Thyristor bidirectionnel suivant la revendication 2, caractérisé par le fait que les zones (19, 25, 36) possédant le premier type de conductivité sont formées par implantation ionique.

4. Thyristor bidirectionnel suivant la revendication 2, caractérisé par le fait que les zones (23, 24, 32, 35) possédant le second type de conductivité sont réalisées par diffusion et possèdent la même épaisseur.

5. Thyristor bidirectionnel suivant l'une des revendications 1 à 4, caractérisé par le fait que la zone de canal (26) du FET est formée par implantation ionique et fait partie de la zone de base (23), située du côté de la cathode, du premier thyristor élémentaire.

6. Thyristor bidirectionnel suivant l'une des revendications 1 à 5, caractérisé par le fait que la zone de base (23 ou 25), située du côté de la cathode, de l'un des thyristors élémentaires forme, avec la zone d'émetteur (32 ou 24), située du côté de l'anode, de l'autre thyristor élémentaire, respectivement une première région (21) ou une seconde région (22) insérée dans le substrat (20) et raccordée par l'intermédiaire d'une barrette (39 ou 40) relativement étroite.

7. Thyristor bidirectionnel suivant la revendication 6, caractérisé par le fait que les régions (21, 22) sont disposées sur une face du substrat (20) de telle manière que la zone d'émetteur (24, 36) située du côté de la cathode, de l'un des thyristors élémentaires, est située en vis-à-vis d'un contact (31, 33) pour la zone d'émetteur (24, 32), située du côté de l'anode, de l'autre des thyristors élémentaires.

8. Thyristor bidirectionnel suivant la revendication 7, caractérisé par le fait que la zone auxiliaire (37) est disposée, dans le substrat (20), dans un évidement de la première région (21), limité par la zone de base (23) située du côté de la cathode, du premier thyristor élémentaire, par la barrette (39) et par la zone d'émetteur (32), située du côté de l'anode, du second thyristor élémentaire.

9. Thyristor bidirectionnel suivant l'une des revendications 1 à 8, caractérisé par le fait que le contact (38) de la zone auxiliaire (37) est relié par l'intermédiaire d'une résistance (34) à l'électrode de commande (29) du FET.

10. Thyristor bidirectionnel suivant l'une des revendications 1 à 8, caractérisé par le fait que le contact de la zone auxiliaire doit être raccordé à une tension auxiliaire ($U_H$) par l'intermédiaire de la voie de charge d'un second FET intégré (16) et que l'électrode de commande du second FET est reliée à l'électrode de commande du premier FET.

FIG1

FIG 2

FIG 3

0 040 816

FIG 4

FIG 5

FIG 6

FIG 7